# EUROPEAN PATENT SPECIFICATION

(11) **EP 2 211 372 B1**
(45) Date of publication and mention of the grant of the patent: **17.08.2016**
(21) Application number: 10151452.9
(22) Date of filing: 22.01.2010
(51) Int. Cl.: H01L 21/67

(54) **Die-ejector**
Chip-Auswerfer
Ejecteur de puces

(30) Priority: 22.01.2009 US 146411 P
(43) Date of publication of application: 28.07.2010
(73) Proprietor: Esec AG, 6330 Cham (CH)
(72) Inventor: Kuster, Roland, 8902, Urdorf (CH); Muehlemann, Ives, 6330, Cham (CH); Urben, Matthias, 6003, Luzern (CH); Kloeckner, Daniel, 6004, Luzern (CH)
(74) Representative: Falk, Urs

(56) References cited:
- EP-A2- 1 596 422
- WO-A1-2008/041273
- JP-A- 2009 272 430

## Description

### FIELD OF THE INVENTION

The invention relates to a die ejector which is used in mounting semiconductor chips in order to support the detachment and removal of a semiconductor chip from a foil.

### BACKGROUND OF THE INVENTION

The semiconductor chips are typically provided on a foil held in a frame (expansion), which is also known as a tape in the field, for the purpose of processing on a semiconductor mounting device. The semiconductor chips adhere to the foil. The frame with the foil is received by a displaceable wafer table. The wafer table is displaced in cycles in order to provide one semiconductor chip after the other at a location and the semiconductor chip which is then provided is received by a chip gripper and placed on a substrate. The removal of the provided semiconductor chip from the foil is supported by a die ejector which is arranged beneath the foil.

In many cases, one or several needles arranged in the die ejector will support the detachment of the semiconductor chip from the foil. Needle-supported methods are known from a large number of patents, e.g. from US 20040105750 or US 7265035.

From US 4921564 a method is known, in which the semiconductor chips may be detached from the foil without the aid of a needle and may be received by the chip gripper. In this method, vacuum is applied to cavities formed in the die ejector, so that the foil is drawn into the cavities and detaches point by point from the semiconductor chips. Further methods in which the semiconductor chips are detached from the foil without the aid of a needle are known from US 2002129899, US 6561743, and US 20050224965.

From US 6561743 a method is known, in which the foil having the semiconductor chip to be detached is drawn over an edge, the semiconductor chip and the foil detaching from one another at the edge. For this purpose, the semiconductor chip is positioned over a slide displaceable in a horizontal direction, the slide being somewhat narrower than the semiconductor chip and being taller by a predetermined distance H than the table plate of the die ejector surrounding the slide. In order that the semiconductor chip detaches from the foil in a controlled manner, firstly the chip gripper is lowered onto the semiconductor chip and vacuum is applied to the semiconductor chip. Because the slide is higher than the table plate and narrower than the semiconductor chip, the foil is drawn off from the semiconductor chip on three sides below the part hanging over the slide. The slide is subsequently moved sideways. The foil is drawn off from the semiconductor chip at the edge of the moving slide by the vacuum prevailing in the resulting opening. The slide is moved so far until the semiconductor chip is detached completely from the foil. A similar method is known from US 2002129899. The space conditions between the die ejector and the frame on which the foil having the semiconductor chips is expanded often do not allow the required lateral displacement of the slide for the outermost semiconductor chips to be detached, because the moving slide would collide with the frame. For this reason, the wafer table or the die ejector must be rotated by 180° for the processing of these semiconductor chips, so that the slide is moved in the other direction and cannot collide with the frame.

From US 7238593 a method is known, in which the foil is drawn over a ramp. As soon as the semiconductor chip is completely detached from the foil, it is located freely in the air for a brief moment and then falls onto the die ejector. For very thin semiconductor chips, the danger exists that the semiconductor chip will roll up.

From WO 2008041273 a method and a die ejector are known for detaching a semiconductor chip from a foil by means of a slide.

### SUMMARY OF THE INVENTION

The invention is based on the object of developing a die ejector, using which all semiconductor chips of a wafer may be removed without having to rotate the die ejector or the wafer table, and which may be adapted for picking semiconductor chips of different sizes by replacing few parts.

The die ejector according to the invention comprises:
a base plate having a slot.
a table plate, which is situated on the base plate and has a slot, which runs parallel to the slot of the base plate,
a channel, to which vacuum can be applied and which opens into the slot of the base plate or the slot of the table plate,
two deflection rollers, which are situated below the base plate at opposite ends of the slot of the base plate,
a drive belt, which is wider than the slot of the base plate and is guided around the two deflection rollers, so that the drive belt seals the slot of the base plate,
a motor to move the drive belt back and forth,
a slide, which is situated in the slot of the base plate and is fastened on the drive belt, the slot of the base plate forming a guide for the slide, and
a slide plate, which is removably fastenable on the slide, and whose width is equal to the width of the slot of the table plate.

The table plate may consist of one single plate or may comprise multiple plates, for example two displaceable side plates and one intermediate plate. The base plate and the table plate are formed either from separate plates or from a single piece of material.

The slide plate preferably has an edge, which protrudes beyond the table plate.

The table plate preferably has an edge which is situated opposite to one of or the named edge of the slide plate, the edge of the table plate being wavy.

Furthermore, it is preferred to have at least two needles situated in the area of the intermediate plate, which protrude into the slot of the table plate and whose tips can be raised and lowered in relation to the surface of the table plate. The needles have for example an oblong needle body, the tips of the needles are oriented perpendicularly or diagonally to the table plate and the needle bodies are rotatable around an axle running parallel to the base plate.

### BRIEF DESCRIPTION OF THE DRAWING FIGURES

The accompanying drawings, which are incorporated into and constitute a part of this specification, illustrate one or more embodiments of the present invention and, together with the detailed description, serve to explain the principles and implementations of the invention. The figures are not drawn true to scale. In the drawings:
- Figure 1: shows a perspective view of a die ejector according to the invention,
- Figure 2: shows parts of the die ejector in a section along line I-I of Figure 1,
- Figure 3: shows parts of the die ejector in a section along line II-II of Figure 1,
- Figures 4A, 4B: show slide plates of the die ejector,
- Figure 5: shows parts of a die ejector having needles in a side view, and
- Figure 6: shows parts of the die ejector in a top view.

### DETAILED DESCRIPTION OF THE INVENTION

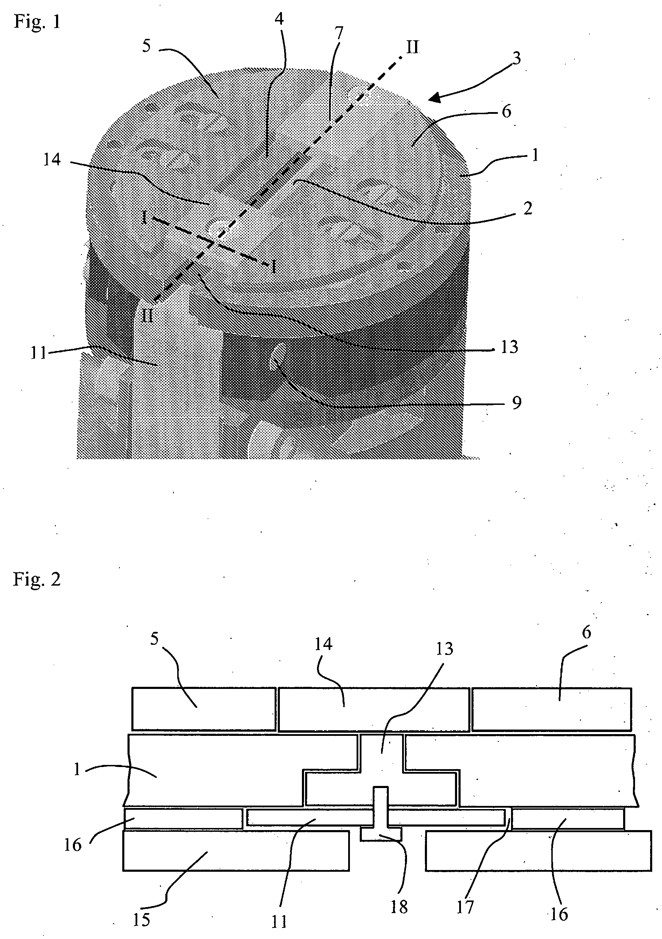

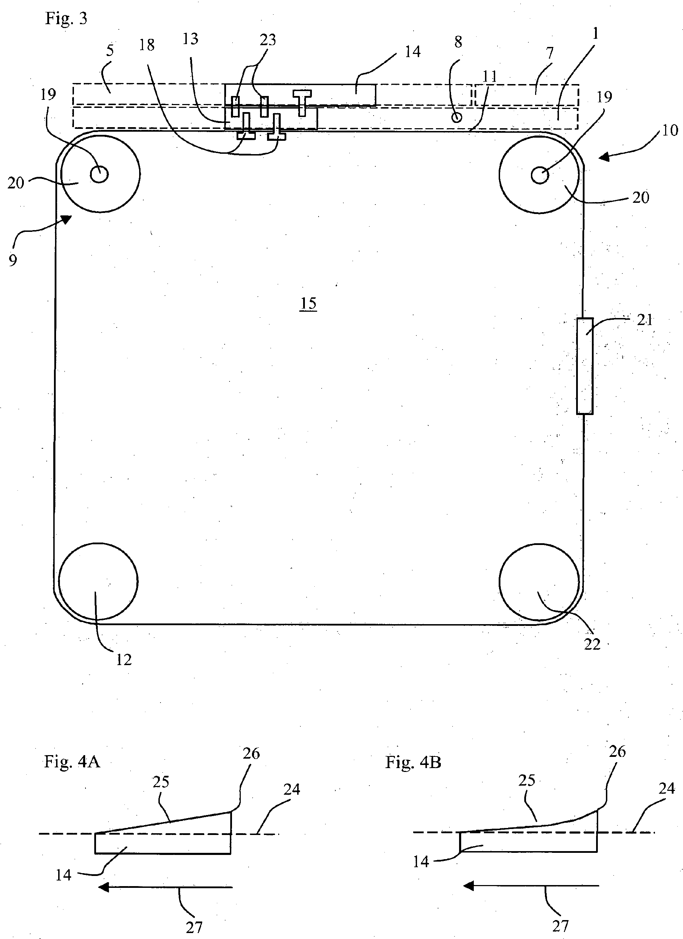

Figure 1 shows a die ejector according to the invention. The die ejector comprises a base plate 1 having a first slot 2. A table plate 3 is situated on the base plate 1. The table plate 3 has a second slot 4, which runs parallel to the slot 2. The width of the second slot 4 is adapted to the width of the semiconductor chip to be detached from the foil and is therefore in the majority of cases wider than the slot 2 of the base plate 1. The table plate 3 can be a single plate, which is manufactured from a single piece of material. The table plate 3 can also be formed by multiple plates, as shown, for example, by two side plates 5, 6 and one intermediate plate 7 which are individually removably fastenable on the base plate 1. The side plates 5, 6 advantageously have slots running perpendicularly to the first slot 2 of the base plate 1 so that they are displaceable perpendicularly to the first slot 2. The width of the slot 4 is thus adjustable. In this case, in the event of a change of the size of the semiconductor chip to be processed, only the intermediate plate 7 must be replaced. However, it is also possible, in particular for applications where only a single type of semiconductor chips is processed, to manufacture the base plate 1 and the table plate 3 from a single piece of material. A channel 8 to which vacuum can be applied (Figure 3) opens into the slot 2 or the slot 4. In the example, the channel 8 is a hole introduced into the base plate 1, which opens into the slot 2 below the intermediate plate 7 and is therefore not visible in Figure 1. Two deflection rollers 9 and 10 (deflection roller 10 is not visible in Figure 1) are situated below the base plate 1 at diametrically opposite ends of the slot 2 of the base plate 1. The two deflection rollers 9 and 10 run parallel to the base plate 1 and parallel to one another and are either mounted so they are rotatable or are not rotatable, i.e., fixed. A drive belt 11 driven by a motor 12 (Figure 3) is guided around the two deflection rollers 9 and 10. The drive belt 11 is wider than the slot 2 of the base plate 1, so that the drive belt 11 seals the slot 2 of the base plate 1 in relation to vacuum from below. A slide 13 is situated in the slot 2 of the base plate 1 and fastened on the drive belt 11. A slide plate 14 is removably fastened on the slide 13. The width of the slide plate 14 is equal to the width of the slot 4 of the table plate 3.

Figure 2 shows parts of the die ejector in a section along line I-I of Figure 1. The base plate 1 is fastened on a base 15 of the die ejector. Two spacers 16 are situated between the base 15 and the base plate 1, so that a slot 17 is formed between the base 15 and the base plate 1, in which the drive belt 11 is laid. The thickness of the spacers 16 is slightly greater than the thickness of the drive belt 11. The cross-section of the slot 2 of the base plate 1 is T-shaped. The cross-section of the slide 13 is also T-shaped. The dimensions of these two cross-sections are adapted to one another, so that the slot 2 forms a guide for the slide 13. The slot 2 is thus a T-shaped groove, which guides the slide 13 both in the predetermined horizontal direction and also vertically. The base plate 1 and the base 15 are advantageously implemented having lubrication pockets, so that the drive belt 11 can be moved with marginal friction in operation. The slide 13 is also advantageously implemented having lubrication pockets. Those surfaces on which the drive belt 11 and the base 15 or the drive belt 11 and the base plate 1 overlap form a gap seal, which seals the slot 2 to vacuum relatively well on its bottom side. The seal is not 100%, but is sufficient. The fastening of the slide 13 on the drive belt 11 is preferably performed using at least one screw 18.

Figure 3 shows parts of the die ejector in a section along line II-II of Figure 1. The deflection rollers 9, 10 are implemented as wheel axles, for example, namely having one thin axle 19 and two wheels 20 of greater diameter situated at a distance to one another, on which the drive belt 11 rests. This solution allows the slide 13 to be moved up into the area between the wheels 20. The ends of the drive belt 11 are connected to one another via a tension mechanism 21 so that the drive belt 11 is tensioned. In the example, the drive belt 11 is guided around the two deflection rollers 9, 10, the motor 12, and a further deflection roller 22. The slide 13 advantageously contains two guide pins 23 situated spaced apart, which engage in associated holes in the slide plate 14, so that the slide plate 14 is automatically aligned upon placement on the slide 13.

The drive belt 11 thus fulfills two functions. It is firstly used for the purpose of moving the slide 13 including slide plate 14 back and forth, and is secondly used for sealing the chamber formed by the base plate 1, the table plate 3 (which is formed if necessary by the intermediate plate 7 and the two side plates 5, 6), and the foil, which is supplied with vacuum through the channel 8, against the ambient pressure.

The die ejector according to the invention offers multiple advantages:
- The die ejector may be adapted to semiconductor chips of different sizes by replacing the table plate 3 and the slide plate 14 or by replacing the intermediate plate 7, the slide plate 14, and displacing the side plates 5, 6.
- The dimensions of the die ejector (base 15, base plate 1) are sufficiently small so that neither the die ejector nor the wafer table must be rotated by 180° to be able to detach all semiconductor chips lying on the edge of the wafer.
- The solution having the drive belt 11 is space-saving and leaves sufficient space to attach a Peltier element on the bottom side of the base plate 1 or in the upper area of the base 15, using which the base plate 1 can be cooled. To dissipate the heat, the hot side of the Peltier element is advantageously connected to a cooling body. In addition, a fan can be installed in the die ejector to transport away the heat.

The surface 25 of the slide plate 14 facing toward the foil having the semiconductor chips can be horizontal and flush with the surface of the table plate 3. However, it is mostly advantageous if the edge 26 of the slide plate 14, on which the foil is drawn off from the semiconductor chip upon displacement of the slide 13, protrudes beyond the table plate 3. Figures 4A and 4B show two possible embodiments of the slide plate 14. The level of the surface of the table plate 3 is shown by a dashed line 24. In the embodiment according to Figure 4A, the surface 25 of the slide plate 14 is implemented as an inclined plane. In the embodiment according to Figure 4B, the surface 25 of the slide plate 14 is implemented as a concave plane. The surface 25 thus forms a ramp which ends at the protruding edge 26. An arrow 27 illustrates the direction of the slide 13 having the slide plate 14, in which the slide 13 is displaced to draw off the foil.

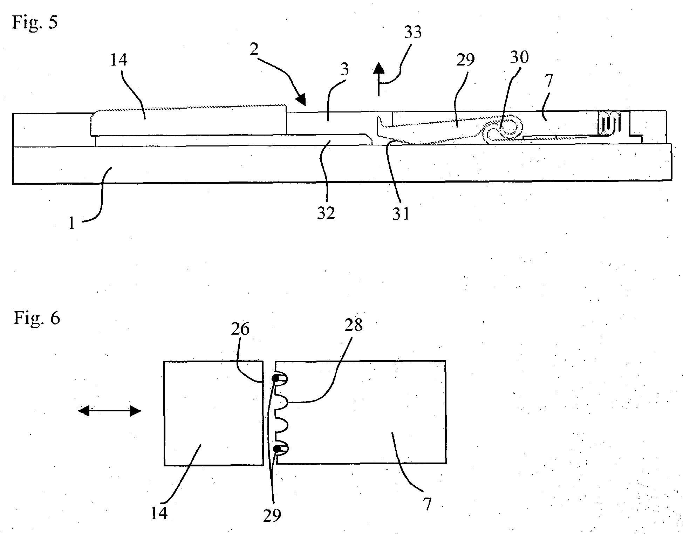

The die ejector is advantageously equipped with two or more needles 29, which are essentially situated in the area of the intermediate plate 7 and protrude into the slot 4 at the edge of the intermediate plate 7. The needles 29 have an oblong needle body, which is rotatable essentially around an axis running parallel to the base plate 1, and the tips of the needles 29 are oriented perpendicularly or diagonally, i.e., slightly inclined, to the table plate 3, so that the tips can be raised and lowered in relation to the table plate 3. In the lowered state, the tips of the needles 29 are located below the surface of the table plate 3, and in the raised state the tips of the needles 29 protrude beyond the surface of the table plate 3. Figure 5 shows a side view, in which only one of the needles 29 is visible. This needle 29 is located in the lowered rest position. In this example, the needles 29 are implemented having a solid-state joint 30 acting as a joint and as a spring and are actuated by sliders 32 attached to the slide plate 14. The solid-state joint 30 is formed in this example by a double loop and allows the front part of the needles 29 to be rotated and thus the tips of the needles 29 to be moved essentially perpendicularly to the table plate 3, namely as follows: If the slide 13 is moved toward the needles 29, the sliders 32 hit a diagonally running surface 31 of the needles 29 and raise the tips of the needles 29 in the direction illustrated by the arrow 33. If the slide 13 is moved away from the needles 29 to draw off the foil, the tips of the needles 29 sink automatically as a result of the spring force, so that subsequently the wafer table can be displaced in order to position the next semiconductor chip above the die ejector, without the needles 29 protruding beyond the table plate 3. The needles 29 are situated so that their tips raise the semiconductor chip on its two comers facing toward the intermediate plate 7.

The table plate 3 or intermediate plate 7 has an edge 28 situated opposite to the edge 26 of the slide plate 14. This edge 28 advantageously has a wavy shape, while the edge 26 of the slide plate 14 is advantageously a linear edge. In this embodiment, vacuum is applied to the foil in this boundary area as soon as vacuum is supplied via the channel 8. Figure 6 shows an example in a top view, the movement direction of the slide plate 14 being shown by an arrow. The term "wavy shape" is to be understood broadly, it includes, for example, a wavy shape having linear sections as shown and also a sawtooth shape and also shapes having other arbitrary recesses. The tips of two needles 29, which are situated in the area of the edge 28, are also shown.

It is clear to one skilled in the art that the described individual parts of the die ejector may be implemented as described, but may also be implemented in diverse modifications, without deviating from the basic idea of the invention, which is that the drive belt 11 has two functions, namely, as described above, the function as a drive of the slide 13 including slide plate 14 and the function of sealing the chamber formed by the base plate 1, the table plate 3 and the foil, which is supplied with vacuum by the channel 8, against the ambient pressure.

## Claims

1. Die ejector, comprising
a base plate (1) having a slot (2),
a table plate (3), which is situated on the base plate (1) and has a slot (4), which runs parallel to the slot (2) of the base plate (1),
a channel (8), to which vacuum can be applied and which opens into the slot (2) of the base plate (1) or the slot (4) of the table plate (3),
two deflection rollers (9, 10), which are situated below the base plate (1) at opposite ends of the slot (2) of the base plate (1),
a drive belt (11), which is wider than the slot (2) of the base plate (1) and is guided around the two deflection rollers (9, 10), so that the drive belt (11) seals the slot (2) of the base plate (1),
a motor (12) to move the drive belt (11) back and forth,
a slide (13), which is situated in the slot (2) of the base plate (1) and is fastened on the drive belt (11), the slot (2) of the base plate (1) forming a guide for the slide (13), and
a slide plate (14), which is removably fastenable on the slide (13), and whose width is equal to the width of the slot (4) of the table plate (3), the table plate (3) either consisting of one single plate or comprising multiple plates and the base plate (1) and the table plate (3) being formed either from separate plates or from a single piece of material.

2. Die ejector according to claim 1, **characterized in that** the slide plate (14) has an edge (26), which protrudes beyond the table plate (3).

3. Die ejector according to claim 1 or 2, the table plate (3) having an edge (28) which is situated opposite to an edge or said edge (26) of the slide plate (14), **characterized in that** the edge (28) of the table plate (3) has a wavy shape.

4. Die ejector according to any of claims 1 to 3, **characterized in that** at least two needles (29) protrude into the slot (4) of the table plate (3) whose tips can be raised and lowered in relation to the surface of the table plate (3).

5. Die ejector according to claim 4, **characterized in that** the needles (29) have an oblong needle body and that the tips of the needles (29) are oriented perpendicularly or diagonally to the table plate (3).

6. Die ejector according to claim 4 or 5, **characterized in that** the needles (29) have a solid-state joint (30), which allows said raising and lowering of the tips of the needles (29).

## Patentansprüche

1. Chip-Auswerfer, umfassend
eine Grundplatte (1) mit einem Schlitz (2),
eine Tischplatte (3), die auf der Grundplatte (1) angeordnet ist und einen Schlitz (4) aufweist, der parallel zum Schlitz (2) der Grundplatte (1) verläuft,
einen mit Vakuum beaufschlagbaren Kanal (8), der in den Schlitz (2) der Grundplatte (1) oder in den Schlitz (4) der Tischplatte (3) mündet,
zwei Umlenkrollen (9, 10), die unterhalb der Grundplatte (1) an gegenüberliegenden Enden des Schlitzes (2) der Grundplatte (1) angeordnet sind,
ein Antriebsband (11), das breiter als der Schlitz (2) der Grundplatte (1) und um die beiden Umlenkrollen (9, 10) geführt ist, so dass das Antriebsband (11) den Schlitz (2) der Grundplatte (1) abdichtet,
einen Motor (12), um das Antriebsband (11) hin und her zu bewegen,
einen Schlitten (13), der im Schlitz (2) der Grundplatte (1) angeordnet und am Antriebsband (11) befestigt ist, wobei der Schlitz (2) der Grundplatte (1) eine Führung für den Schlitten (13) bildet, und
einer Schlittenplatte (14), die lösbar am Schlitten (13) befestigbar ist, und deren Breite gleich der Breite des Schlitzes (4) der Tischplatte (3) ist, wobei die Tischplatte (3) aus einer einzigen Platte besteht oder mehrere Platten umfasst und wobei die Grundplatte (1) und die Tischplatte (3) entweder aus getrennten Platten oder aus einem einzigen Stück Material gebildet sind.

2. Chip-Auswerfer nach Anspruch 1, **dadurch gekennzeichnet, dass** die Schlittenplatte (14) eine Kante (26) aufweist, die über die Tischplatte (3) hervorsteht.

3. Chip-Auswerfer nach Anspruch 1 oder 2, wobei die Tischplatte (3) eine Kante (28) aufweist, die einer bzw. der genannten Kante (26) der Schlittenplatte (14) gegenüberliegt, **dadurch gekennzeichnet, dass** die Kante (28) der Tischplatte (3) eine Wellenform hat.

4. Chip-Auswerfer nach einem der Ansprüche 1 bis 3, **dadurch gekennzeichnet, dass** mindestens zwei Nadeln (29) in den Schlitz (4) der Tischplatte (3) hineinragen, deren Spitzen in Bezug auf die Oberfläche der Tischplatte (3) heb- und senkbar sind.

5. Chip-Auswerfer nach Anspruch 4, **dadurch gekennzeichnet, dass** die Nadeln (29) einen länglichen Nadelkörper aufweisen und dass die Spitzen der Nadeln (29) senkrecht oder schräg zur Tischplatte (3) ausgerichtet sind.

6. Chip-Auswerfer nach Anspruch 4 oder 5, **dadurch gekennzeichnet, dass** die Nadeln (29) ein Festkörpergelenk (30) aufweisen, das das besagte Heben und Senken der Spitzen der Nadeln (29) ermöglicht.

## Revendications

1. Ejecteur de puces, comprenant
une plaque de base (1) ayant une rainure (2),
une plaque de table (3), qui est située sur la plaque de base (1) et possède une rainure (4), qui s'étend de façon parallèle à la rainure (2) de la plaque de base (1),
un canal (8), auquel un vide d'air peut être appliqué et qui s'ouvre dans la rainure (2) de la plaque de base (1) ou la rainure (4) de la plaque de table (3),
deux rouleaux de déviation (9, 10), qui sont situés sous la plaque de base (1) aux extrémités opposées de la rainure (2) de la plaque de base (1),
une courroie d'entraînement (11), qui est plus large que la rainure (2) de la plaque de base (1) et qui est guidée autour des deux rouleaux de déviation (9, 10), pour que la courroie d'entraînement (11) scelle la rainure (2) de la plaque de base (1),
un moteur (12) pour déplacer la courroie d'entraînement (11) en arrière et en avant,
une glissière (13), qui est située dans la rainure (2) de la plaque de base (1) et qui est fixée sur la courroie d'entraînement (11), la rainure (2) de la plaque de base (1) formant un guide pour la glissière (13), et
une plaque coulissante (14), qui est fixable de façon amovible sur la glissière (13), et dont la largeur est égale à la largeur de la rainure (4) de la plaque de table (3), la plaque de table (3) se composant soit d'une seule plaque ou comprenant de multiples plaques et la plaque de base (1) et la plaque de table (3) étant formées soit à partir de plaques séparées, soit à partir d'un seul morceau de matériel.

2. Ejecteur de puces selon la revendication 1, **caractérisé en ce que** la plaque coulissante (14) possède un bord (26), qui est en saillie au-delà de la plaque de table (3).

3. Ejecteur de puces selon la revendication 1 ou 2, la plaque de table (3) ayant un bord (28) qui est situé à l'opposé d'un bord ou dudit bord (26) de la plaque coulissante (14), **caractérisé en ce que** le bord (28) de la plaque de table (3) possède une forme ondulée.

4. Ejecteur de puces selon l'une des revendications 1 à 3, **caractérisé en ce que** au moins deux aiguilles (29) sont en saillie dans la rainure (4) de la plaque de table (3) dont les pointes peuvent être soulevées et abaissées par rapport à la surface de la plaque de table (3).

5. Ejecteur de puces selon la revendication 4, **caractérisé en ce que** les aiguilles (29) possèdent un corps d'aiguille oblong et que les pointes des aiguilles (29) sont orientées de façon perpendiculaire ou en diagonal par rapport à la plaque de table (3).

6. Ejecteur de puces selon la revendication 4 ou 5, **caractérisé en ce que** les aiguilles (29) ont un joint à l'état solide (30), qui permet ledit levage ou abaissement des pointes des aiguilles (29).
